# EUROPEAN PATENT APPLICATION

(11) **EP 2 282 625 A2**
(43) Date of publication of application: **09.02.2011**
(21) Application number: 10166451.4
(22) Date of filing: 18.06.2010
(51) Int. Cl.: H05K 9/00

(54) **Display apparatus for preventing electromagnetic interference (EMI)**

(30) Priority: 04.08.2009 KR 20090071670
(71) Applicant: Samsung Electronics Co., Ltd., Suwon-si, Gyeonggi-do 442-742 (KR)
(72) Inventor: Han, Joon-mok, Gyeonggi-do (KR)
(74) Representative: Davies, Robert Ean

(57) **Abstract**

A display apparatus is provided, which includes a front cover having an opening through which an image is exposed; a rear cover which is coupled to the front cover and which is made of conductive materials; an image providing panel which provides an image through the opening of the front cover; a protection filter which is disposed between the front cover and the image providing panel and which has a conductive film to shield electromagnetic waves; and a connection unit which is in contact with an edge surface of the protection filter. The connection unit electrically connects the rear cover to an exposed end of the conductive film which is exposed on the edge surface.

## Description

### CROSS-REFERENCE TO RELATED APPLICATIONS

This application claims priority from Korean Patent Application No. 10-2009-0071670, filed on August 4, 2009, in the Korean Intellectual Property Office, the disclosure of which is incorporated herein in its entirety by reference.

### BACKGROUND

### 1. Field

Apparatuses consistent with the present disclosure relate to a display apparatus, and more particularly, to a display apparatus which prevents an electromagnetic interference (EMI).

### 2. Description of the Related Art

Cathode ray tubes (CRTs) have been used as display apparatuses. However, CRTs are tending to be replaced by flat panel displays (FPDs), such as liquid crystal displays (LCDs) or plasma display panels (PDPs).

Such FPDs generate electromagnetic waves in the same manner as other electronic apparatuses. As widely known, electromagnetic waves are harmful to the human body, and an electromagnetic interference (EMI) may occur if the intensity of the electromagnetic waves exceeds a predetermined level.

Herein, EMI refers to a phenomenon where electromagnetic waves which are generated by an electronic device, interfere with operations of another electronic device. In particular, PDPs among FPDs need to be prevented from EMI because in PDPs a high voltage is used to discharge gas to generate a plasma.

### SUMMARY

Exemplary embodiments overcome the above disadvantages and other disadvantages not described above. Also, the present invention is not required to overcome the disadvantages described above, and an exemplary embodiment of the present invention may not overcome any of the problems described above.

The present disclosure provides a display apparatus for preventing an electromagnetic interference (EMI), thereby reducing manufacturing costs of the display apparatus.

According to an aspect of the present disclosure, there is provided a display apparatus which includes a front cover having an opening through which an image is exposed, a rear cover which is coupled to the front cover and is made of conductive materials, an image providing panel which provides an image through the opening of the front cover, a protection filter which is disposed between the front cover and the image providing panel and which has a conductive film to shield electromagnetic waves, and a connection unit which is disposed to come in contact with an edge surface of the protection filter, and electrically connects the rear cover to an exposed end of the conductive film which is exposed on the edge surface.

The connection unit may include a bracket member which is coupled to the rear cover and is made of conductive materials, and a gasket member which comes in contact with the exposed end of the conductive film and the bracket member, and which is made of conductive materials.

The gasket member may comprise a cushion member which absorbs external shocks applied to the protection filter, and a casing member which encloses the cushion member and which is made of conductive materials.

The gasket member may include a rear surface contact portion which comes in contact with a rear surface of the protection filter. The gasket member may also include an edge surface contact portion which extends from the rear surface contact portion and which comes in contact with the edge surface of the protection filter.

The bracket member may include a mounting portion which is mounted to the rear cover, and a gasket support portion which extends from the mounting portion and which supports the gasket member.

The gasket support portion may include a horizontal supporter which is arranged in parallel with the protection filter to support the rear surface contact portion of the gasket member. The gasket support portion may also include an inclined supporter which is inclined to a predetermined angle from the horizontal supporter, and which supports the edge surface contact portion of the gasket member.

The protection filter may include a transparent plate which is formed on a rear surface of the conductive film, a first functional film which is formed on a front surface of the transparent plate, and a second functional film which is formed on the conductive film.

The connection unit may include two longitudinal individual connection units which respectively come in contact with two longitudinal edge surfaces of the protection filter, and two transverse individual connection units which respectively come in contact with two transverse edge surfaces of the protection filter.

The display apparatus may be a plasma display apparatus.

### BRIEF DESCRIPTION OF THE DRAWINGS

The above and/or other aspects of the present disclosure will be more apparent by describing certain exemplary embodiments thereof with reference to the attached drawings, in which:
FIG. 1 is a schematic perspective view of a plasma display apparatus according to an exemplary embodiment of the present invention;
FIG. 2 is a sectional view of the plasma display apparatus of FIG. 1;
FIG. 3 is a perspective view of a connection unit included in the plasma display apparatus of FIG. 1;
FIG. 4 is a magnifying view of the connection unit of FIG. 2 and other neighboring units included in the plasma display apparatus of FIG. 1;
FIG. 5 is a graph showing an EMI characteristic of a conventional display apparatus applying an AG-paste; and
FIG. 6 is a graph showing an EMI characteristic of the plasma display apparatus of FIG. 1.

### DETAILED DESCRIPTION OF EXEMPLARY EMBODIMENTS

Hereinafter, exemplary embodiments will now be described in greater detail with reference to the accompanying drawings in which the same reference numerals are used for the same elements when they are depicted in different drawings.

The embodiments described below are provided to assist in a comprehensive understanding of the disclosure. Also, well-known functions or constructions are not described in detail since they would obscure the invention with unnecessary detail.

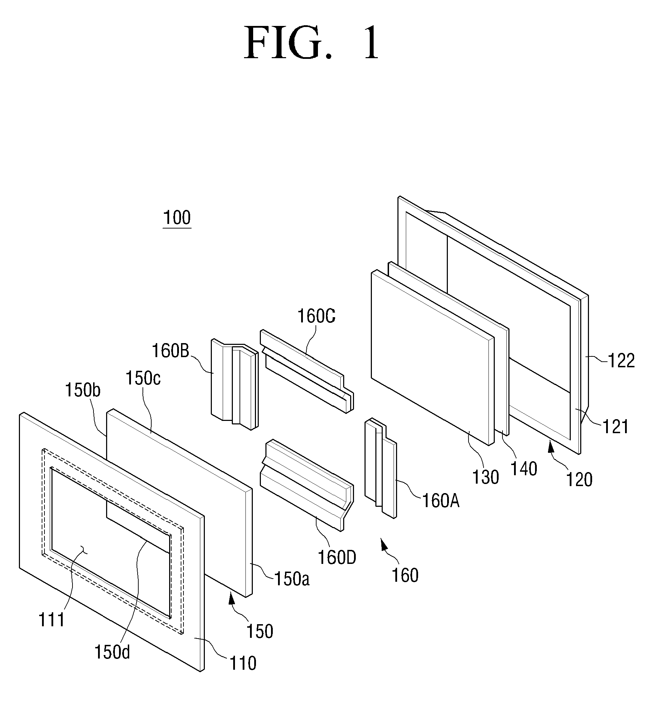

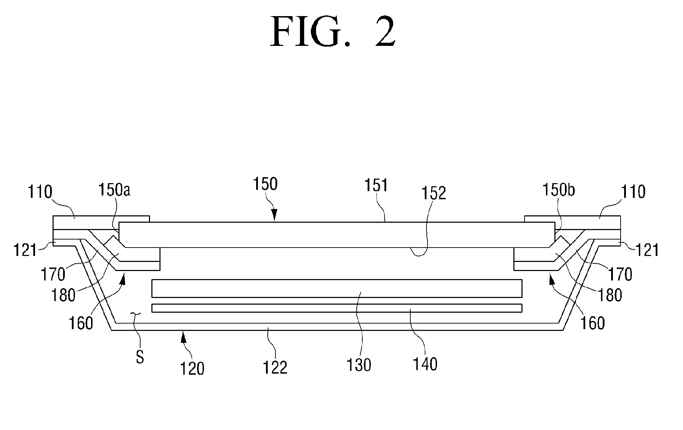

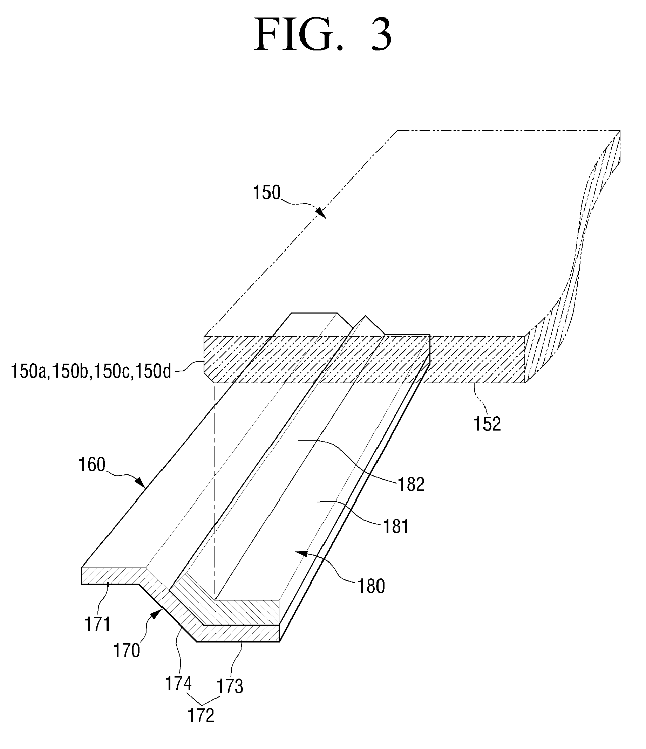

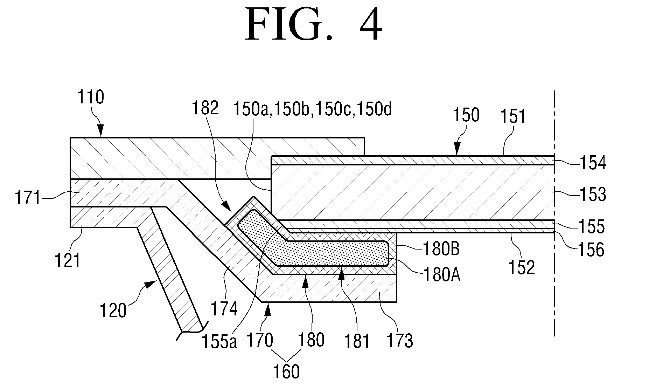

FIG. 1 is a schematic perspective view of a plasma display apparatus according to an exemplary embodiment, FIG. 2 is a sectional view of the plasma display apparatus of FIG. 1, FIG. 3 is a perspective view of a connection unit included in the plasma display apparatus of FIG. 1, and FIG. 4 is a magnifying view of the connection unit of FIG. 2 and other neighboring units included in the plasma display apparatus of FIG. 1.

As shown in FIGS. 1 to 4, a plasma display apparatus 100 according to an exemplary embodiment includes a front cover 110, a rear cover 120, an image providing panel 130, a driving substrate 140, a protection filter 150 and a connection unit 160.

The front cover 110 takes the form of a substantially rectangular panel, and includes an opening 111 formed therethrough in the form of a rectangle. The opening 111 is formed in the central area of the front cover 110 and enables an image to be exposed so that a user may view the image through the opening 111. Additionally, the front cover 110 is made of light and flexible plastic materials.

The rear cover 120 includes a border 121 with a rectangular shape, and an accommodation portion 122 concavely extending from the border 121. As shown in FIG. 2, the border 121 of the rear cover 120 is connected to an inner surface of the front cover 110, so that an inner space S is formed between the front cover 110 and the accommodation portion 122 of the rear cover 120. The inner space S may house the image providing panel 130, the driving substrate 140 and the protection filter 150.

The rear cover 120 is made of metallic materials such as aluminum. Accordingly, the rear cover 120 can prevent electromagnetic waves formed in the inner space S in the display apparatus 100 from leaking out.

The image providing panel 130 embodies an image and projects the image onto the front cover 110. The image providing panel 130 has a substantially rectangular shape, and is disposed in the central area of the inner space S of the display apparatus 100. Additionally, the image providing panel 130 has a configuration in which a plurality of discharge cells are uniformly arranged between two glass plates which face each other. When gas such as helium (He), neon (Ne) or argon (Ar) is being electrically discharged from the plurality of discharge cells, ultraviolet rays are generated. Additionally, the generated ultraviolet rays emit light using red, green or blue fluorescent materials which are coated onto the plurality of discharge cells. As a result, visible rays may be generated according to color of fluorescent materials. Therefore, each of the plurality of discharge cells may form a single pixel.

To electrically discharge gas from the discharge cells, a high voltage is applied to the image providing panel 130 at a predetermined period (for example, 60 Hz). The high voltage applied to the image providing panel 130 may cause relatively intense electromagnetic waves to be formed in the display apparatus 100.

The driving substrate 140 is disposed in the rear of the image providing panel 130. The driving substrate 140 controls operations of the image providing panel 130.

The protection filter 150 is provided to prevent the electromagnetic waves, which are formed in the display apparatus 100, from leaking out toward the front of the display apparatus 100. The protection filter 150 is disposed between the front cover 110 and the image providing panel 130. Additionally, a front surface 151 of the protection filter 150 comes in close contact with the inner surface of the front cover 110 by the connection unit 160 which pushes a rear surface 152 of the protection filter 150 towards the front cover 110.

As shown in FIG. 1, the protection filter 150 takes the form of a substantially rectangular panel. The protection filter 150 includes a pair of longitudinal edge surfaces 150a and 150b and a pair of transverse edge surfaces 150c and 150d. As shown in FIG. 3, each of the edge surfaces 150a to 150d has an obliquely chamfered end. This chamfered end may prevent the protection filter 150 from being damaged due to external shocks or collision with other component parts during assembly or transport.

As shown in FIG. 4, the protection filter 150 includes a transparent plate 153, a first functional film 154 formed on a front surface of the transparent pate 153, a conductive film 155 formed on a rear surface of the transparent pate 153, and a second functional film 156 formed on a rear surface of the conductive film 155.

The transparent plate 153 takes the form of a substantially rectangular panel, and may be fabricated with glass materials or polymer resins with great transparency.

The first functional film 154 is an anti-reflection (AR) film for reducing reflection of light incident from outside, and the second functional film 156 is a color correction film having a Ne-cut function. In another exemplary embodiment of the present invention, various functional films, for example a near-infrared shielding film and an anti-glare (AG) film, may be additionally formed on the front surface or the rear surface of the transparent plate 153. The conductive film 155 is used to prevent electromagnetic waves, generated by the display apparatus 100, from leaking out. The conductive film 155 may be made of metallic materials such as silver (Ag) or aluminum (Al), and may be attached or coated onto the transparent plate 153 using a spray method. If the conductive film 155, which is made of metallic materials, is exposed to air, the conductive film 155 may corrode. In order to avoid corrosion of the conductive film 155, in the exemplary embodiment of the present invention, the second functional film 156 is configured to cover the conductive film 155.. The conductive film 155 is disposed on the rear surface of the transparent plate 153 as shown in FIG. 4. However, the conductive film 155 may also be formed on the front surface of the transparent plate 153.

The connection unit 160 is disposed in a space formed between the protection filter 150 and the border 121 of the rear cover 120, as shown in FIG. 2. The connection unit 160 electrically connects the conductive film 155 of the protection filter 150 to the rear cover 120. According to this embodiment, the connection unit 160 may prevent electromagnetic waves generated by the display apparatus 100 from leaking out through the space formed between the protection filter 150 and the border 121 of the rear cover 120.

As shown in FIG. 1, the connection unit 160 includes a pair of longitudinal individual connection units 160A and 160B, and a pair of transverse individual connection units 160C and 160D. The pair of longitudinal individual connection units 160A and 160B respectively come in contact with the pair of longitudinal edge surfaces 150a and 150b of the protection filter 150, and the pair of transverse individual connection units 160C and 160D respectively come in contact with the pair of transverse edge surfaces 150c and 150d of the protection filter 150.

In other words, the connection unit 160 is configured with four individual connection units 160A to 160D, and four individual connection units 160A to 160D which have a slight difference in length, but are configured to be substantially identical. Therefore, the following description of the connection unit 160 with reference to FIGS. 3 and 4 may equally be applied to the individual connection units 160A to 160D.

As shown in FIGS. 3 and 4, the connection unit 160 includes a bracket member 170 and a gasket member 180.

The bracket member 170 includes a mounting portion 171 and a gasket support portion 172. The mounting portion 171 is mounted to the front cover 110 and the border 121 of the rear cover 120. The gasket support portion 172 supports the gasket member 180, so that the protection filter 150, which is in contact with the gasket member 180, is also supported. Therefore, the protection filter 150 may remain in close contact with the front cover 110. The gasket support portion 172 includes a horizontal supporter 173, which is arranged in parallel with the protection filter 150, and an inclined supporter 174 which is inclined to a predetermined angle from the horizontal supporter 173.

The bracket member 170 is made of conductive materials, such as, for example, silver or aluminum. Accordingly, the bracket member 170 may shield electromagnetic waves in the same manner as the rear cover 120.

As shown in FIG. 4, the gasket member 180 includes a cushion member 180A, and a casing member 180B which encloses the cushion member 180A. The cushion member 180A is provided to absorb external shocks which are applied to the protection filter 150. The cushion member 180A may be made of cloth or cotton, or polymer resins such as polyurethane capable of absorbing shocks. The casing member 180B is provided to electrically connect the conductive film 155 of the protection filter 150 and the bracket member 170, and may be made of metallic materials, such as, for example, silver or aluminum. Additionally, the gasket member 180 includes a rear surface contact portion 181 and an edge surface contact portion 182, as shown in FIGS. 3 and 4. The rear surface contact portion 181 is disposed between the rear surface 152 of the protection filter 150 and the horizontal supporter 173 of the bracket member 170, and supports the rear surface 152 of the protection filter 150. The edge surface contact portion 182 is disposed between the edge surfaces 150a to 150d of the protection filter 150 and the inclined supporter 174 of the bracket member 170, and supports the edge surfaces 150a to 150d of the protection filter 150.

As shown in FIG. 4, the edge surface contact portion 182 of the gasket member 180 comes in contact with an exposed end 155a of the conductive film 155 which is exposed on the edge surfaces 150a to 150d of the protection filter 150. In more detail, the casing member 180B on the edge surface contact portion 182 of the gasket member 180 comes in contact with the exposed end 155a of the conductive film 155. Since the casing member 180B has a conductivity, the conductive film 155 of the protection filter 150 may be electrically connected to the bracket member 170.

The gasket member 180 is disposed between the protection filter 150 and the bracket member 170, as described above. As a result, the gasket member 180 can absorb external shocks which are applied to the protection filter 150. Further, the gasket member 180 can electrically connect the conductive film 155 of the protection filter 150 and the bracket member 170.

The space between the border 121 of the rear cover 120 and the edge surfaces 150a to 150d of the protection filter 150 may be covered substantially by the connection unit 160 which electrically connects the rear cover 120 to the protection filter 150. As a result, an amount of electromagnetic waves, leaking out from the display apparatus 100 through the space between the rear cover 120 and the protection filter 150, may be reduced, and thus it is possible to prevent EMI which are caused by the electromagnetic waves generated by the display apparatus 100.

Techniques for applying a gasket member to prevent the EMI have been conventionally known. However, in a conventional display apparatus, a gasket member comes in contact with only a rear surface of a protection filter. However, it does not come in contact with an edge surface of the protection filter. In the conventional display apparatus, a conductive material, called as an AG-paste, is coated onto a border of the rear surface of the protection filter using a spray method to electrically connect a conductive film of the protection filter to the gasket member. Additionally, the AG-paste comes in contact with the conductive film of the protection filter and the gasket member, and therefore the conductive film of the protection filter may be electrically connected to the gasket member.

As described above, in the conventional display apparatus, the AG-paste is applied to electrically connect the conductive film of the protection filter to the gasket member. However, in the display apparatus 100 according to the exemplary embodiment of the present invention, the edge surface contact portion 182 of the gasket member 180 comes in direct contact with the exposed end 155a of the conductive film 155 of the protection filter 150, and thus the AG-paste is not required. Accordingly, there is no need to form an AG-paste, and therefore it is possible to reduce the number of manufacturing operations. As a result, the manufacturing costs of the display apparatus 100 can be reduced, compared to the manufacturing costs of a conventional display apparatus.

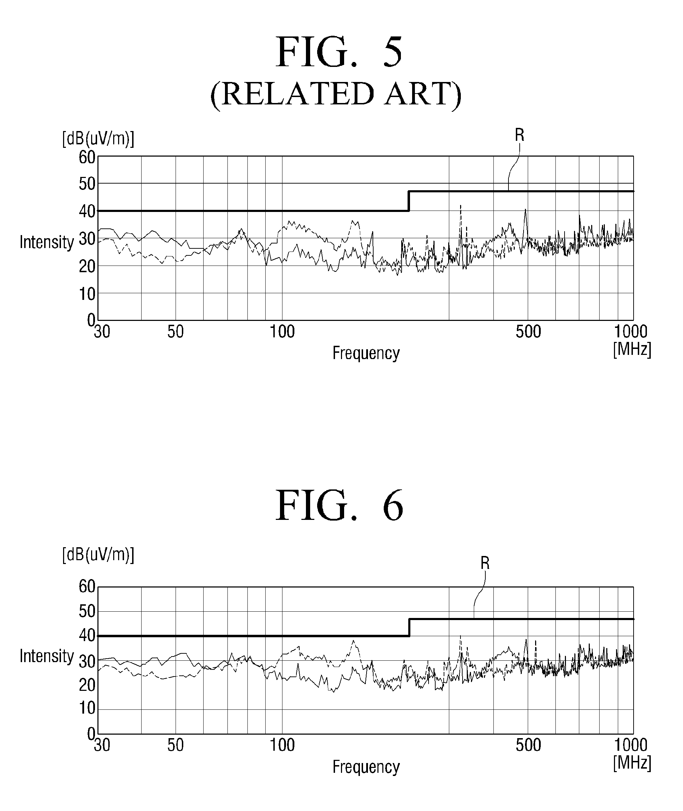

FIG. 5 is a graph showing the result of measuring electromagnetic waves in a conventional display apparatus using an AG-paste, and FIG. 6 is a graph showing the result of measuring electromagnetic waves in the display apparatus 100 shown in FIG. 1. In the graphs shown in FIGS. 5 and 6, a horizontal axis represents a frequency of measured electromagnetic waves, and a vertical axis represents an intensity of measured electromagnetic waves. In addition, a solid line represents data obtained when an antenna is disposed perpendicular to a display apparatus. A dashed line represents data obtained when an antenna is disposed in parallel with the display apparatus. Furthermore, 'R' represents an allowable reference line for EMI according to a frequency band.

First, as shown in FIG. 5, neither the solid line nor the dashed line intersects the allowable reference line R. Likewise, as shown in FIG. 6, neither the solid line nor the dashed line intersects the allowable reference line R. Therefore, the display apparatus 100 according to the exemplary embodiment of the present invention may have an EMI prevention effect similar to that of the conventional display apparatus, even though, the AG-paste is not used.

The foregoing exemplary embodiments and advantages are merely exemplary and are not to be construed as limiting the present invention. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A display apparatus comprising:
a front cover comprising an opening through which an image is exposed;
a rear cover which is coupled to the front cover and which is made of conductive materials;
an image providing panel which provides an image through the opening of the front cover;
a protection filter which is disposed between the front cover and the image providing panel and which has a conductive film to shield electromagnetic waves; and
a connection unit which is disposed in contact with an edge surface of the protection filter, and which electrically connects the rear cover to an exposed end of the conductive film which is exposed on the edge surface.

2. The display apparatus as claimed in claim 1, wherein the connection unit comprises:
a bracket member which is coupled to the rear cover and is made of conductive materials; and
a gasket member which comes in contact with the exposed end of the conductive film and the bracket member, and which is made of conductive materials.

3. The display apparatus as claimed in claim 2, wherein the gasket member comprises:
a cushion member which absorbs external shocks applied to the protection filter; and
a casing member which encloses the cushion member and which is made of conductive materials.

4. The display apparatus as claimed in claim 2, wherein the gasket member comprises:
a rear surface contact portion in contact with a rear surface of the protection filter; and
an edge surface contact portion which extends from the rear surface contact portion and which is in contact with the edge surface of the protection filter.

5. The display apparatus as claimed in claim 4, wherein the bracket member comprises:
a mounting portion which is mounted to the rear cover; and
a gasket support portion which extends from the mounting portion and which supports the gasket member.

6. The display apparatus as claimed in claim 5, wherein the gasket support portion comprises:
a horizontal supporter which is arranged in parallel with the protection filter to support the rear surface contact portion of the gasket member; and
an inclined supporter which is inclined to a predetermined angle from the horizontal supporter, and which supports the edge surface contact portion of the gasket member.

7. The display apparatus as claimed in claim 1, wherein the protection filter comprises:
a transparent plate which is formed on a rear surface of the conductive film;
a first functional film which is formed on a front surface of the transparent plate; and
a second functional film which is formed on the conductive film.

8. The display apparatus as claimed in claim 1, wherein the connection unit comprises:
two longitudinal individual connection units respectively in contact with two longitudinal edge surfaces of the protection filter; and
two transverse individual connection units respectively in contact with two transverse edge surfaces of the protection filter.

9. The display apparatus as claimed in claim 1, wherein the display apparatus is a plasma display apparatus.
